# EUROPEAN PATENT APPLICATION

(11) **EP 1 389 799 A1**
(43) Date of publication of application: **18.02.2004**
(21) Application number: 02018065.9
(22) Date of filing: 13.08.2002
(51) Int. Cl.: H01L 21/20, H01L 21/3105, H01L 21/316, H01L 21/335, H01L 33/00

(54) **Method for production of a layered structure with nanocrystals in a dielectric layer**

(71) Applicant: Aarhus University, 8000 Aarhus C (DK)
(72) Inventor: Gaiduk, Peter, 8000 Arhus C (DK); Lundsgaard Hansen, John, 8210 Arhus V (DK); Nylandsted Larsen, Arne, 8260 Viby J. (DK); Heinig, Karl-Heinz, 01237 Dresden (DE)
(74) Representative: Nielsen, Leif L.

(57) **Abstract**

A method for production of a sandwich layered structure with nanocrystals in a dielectric layer for application in a memory device.

## Description

### FIELD OF THE INVENTION

The present invention relates to layered structures with nanocrystals in dielectric layers. More specifically, the invention relates to new electronic memory devices making use of nanocrystals as charge storage elements.

### BACKGROUND OF THE INVENTION

Microelectronics revolution has largely contributed to the increase of the quality of life of citizens throughout the world during the past 30 years. The main driving force for this revolution has been the miniaturization of integrated circuits so that more and more information is stored per surface area. The fabrication of memory devices with higher information storage density and lower power consumption positively affects the miniaturization of every day equipment used by the citizen as well as it enables the invention of new memory devices. Quality of life, health, safety is directly affected by the above trend.

Current electronic memory technology may be divided into two main categories, nonvolatile (NVM) and volatile memories (with major representative DRAMs). The former are characterized in general by long retention times of the stored information and relatively slow write time, while the latter are characterized by fast write time but short retention time. In NVM (Flash or EEPROM) devices, the information is stored within a polysilicon layer that is buried within the gate oxide of a MOS transistor. The polysilicon is charged from charges coming from the channel area of the transistor. Write and erase takes place by changing adequately the potential of the 3 terminals of the device. A drawback of this technology is that the distance of polysilicon layer from the channel, actually at 7 nm, cannot be decreased any more because there is a risk to reduce dramatically the retention time of the devices. This fact prohibits the complete device dimensions to be scaled down and, on the other hand, necessitates high voltage levels to charge the polysilicon layer from the channel area. To generate these voltages, space consuming specialized circuitry on the chip is used.

In the case of DRAM devices, space economy is the main driving force to investigate other alternatives as the one proposed here since being single-element devices, the proposed memories could be densely packed and also integrated relatively easily with logic transistors.

In this connection, the production of new charge storage elements has been proposed in 1996 by Hanafi et al. in the article 'Fast and long retention time nano-crystal memory' published in IEEE Trans. Electron Dev. 43, p.1553, Sept 1996. The proposal is to use nanocrystals formed by ion implantation in CVD grown Si rich oxide and annealing within the gate oxide. It has been concluded that the nanocrystal memory that operates at room temperature as compared to polysilicon floating-gate NVM devices has several advantages, such as much shorter writing times (100 ns to compare with 1 ms in NVM), lower operating voltages (5 V to compare with 15 V in NVM), better endurance cycles (10⁹ to compare with 10⁶ in NVM), and longer retention times for the same tunneling oxide thickness. It was also concluded that ion implantation offers several advantages over deposition techniques because of its wide familiarity and use in Si technology. Hence, costs are expected to be lower while the performances of the fabricated memory devices are higher.

In a "nanocrystal" memory, the nanocrystals can be placed much closer to the channel without loosing their charge contrary to what is observed for a polysilicon layer. Due to the electrical isolation of the nanocrystals in the lateral dimensions, charge loss occurs only from nanocrystals close to 'weak regions' of the device. Hanafis work, as mentioned above, has demonstrated the charge storage capability of nanocrystals and related it with single electron phenomena observable at room temperature due to their small sizes. But the processes proposed for the formation of nanocrystals showed no control of their size, density and exact positioning in the oxide layer. Furthermore, ion implantation results in crystal defects which may lead to improper functioning when used as an electronic memory device.

In a somewhat similar way, Guo et al. in their article 'A silicon Single-Electron transistor memory operating at room temperature', published in Science 275, p. 649 Jan. 1997, have demonstrated that, when the size of a polysilicon charge storage layer becomes very small, single electron phenomena clearly appear at room temperature resulting in "staircase" characteristics of the threshold voltage as a function of the gate voltage of the device. However, in the approach of Guo et al., advanced e-beam lithography and self-limited oxidation processes have been used in order to decrease the dot size and achieve room temperature operation. The use of advanced lithography to draw feature sizes of 30 nm is important because it proves basic concepts or generates new ones but remains, at best, a remote only option for the industry.

It is also worth to mention the first attempt to fabricate a single electron memory that was made by Yano et al in 1994 'Room temperature single electron memory', published in IEEE Trans. Electron Dev. 41, p.16228 (1994). This device has write and erase times in the µs range and retention times of one day, two characteristics which stand between floating-gate NVM and DRAM properties. The approach by Yano et al. is different, since they used a thin polysilicon layer that connects the source and drain of a MOS Thin Film Transistor which serves at the same time as the channel and as the storage element of the memory device. They speculate that the current always finds a percolation path in the polysilicon layer from which escaping electrons charge a nanocrystal in the same polysilicon layer. The electrostating potential of the nanocrystal influences the current flow. A gate can modulate the potential of the nanocrystal so that the current flows again in this transistor. The main drawback of this effort is that the statistical character of the fabrication process renders quite improbable the control of the electron path and of the charging of the nanocrystals . This has been recognized by the inventors in a series of recent papers, for example the article by K. Yano et al. 'Status of single electron memories' Intern. Electron Dev. Meeting, Dec. 1998 and references therein.

The formation of Ge-nanocrystals in Si-oxide by a different approach is disclosed in US patent no. 5 783 498. These nanocrystals are proposed for photoluminescence devices and optical switches. In this method, a Ge doped silicon dioxide film is formed on a substrate by atmospheric pressure chemical vapour deposition (APCVD) after which the substrate is annealed in a non-reactive or reducing atmosphere at a temperature of 600-900°C for Ge nanocrystal formation in the SiO₂ film.

For the production of memory devices, it is important that nanocrystals are arranged in a plane parallel with the Si/SiO₂ interface. This cannot be achieved in a satisfactory way by APCVD, because no thin layer of Ge nanocrystals can be produced by this method. Therefore, the method as described in US patent no. 5 783 498 is not suited for the production of memory devices.

As published on the Internet by University of California at Berkeley, it is known from the article "Charge storage effect in a trilayer structure comprising germanium nanocrystals" by C.L.Heng et al. that charge storage effects may be achieved by a trilayer structure consisting of a Ge layer embedded between two SiO₂ layers. Ge nanocrystals are formed in this sandwich arrangement during annealing at a temperature of 1000°C for 300 seconds. The lower SiO₂ is achieved by rapid thermal oxidation of the p-type Si substrate, the Ge layer itself is obtained by electron beam evaporation, and the upper SiO₂ on top of a Ge layer is created by a sputtering process. As published on the Internet by L.W.Teo et al. at University of California at Berkeley, "Synthesis of germanium nanocrystals and its possible application in memory devices" and in Applied Physics Letters Vol. 80, no. 11, by W.K.Choi, "Observation of memory effect in germanium nanocrystals embedded in an amorphous silicon oxide matrix of a metal-insulator-semiconductor structure", a different method for production of Ge nanocrystals in SiO₂ is known. In this method, a Ge+SiO₂ layer is formed by radio frequency sputtering, which is embedded between two SiO₂ layers. Ge nanocrystals are formed by rapid thermal annealing at 1000°C for 300 seconds. Sputtering techniques for the formation of a Ge layer result in a thickness of such layers that is hard to control, especially for thin layers, which results in a large variety of sizes of these germanium crystals in such a layer as also reported in these articles. Furthermore, the thickness of a sputtered Ge layer is limited to a minimum of a few nanometer, resulting in a final distribution of germanium crystals in a relatively thick layer, whereas it is desirable to have layers of sub-nanometer thickness. Even further, the methods as described suffer from the fact, well-known for sputtered layers, that these contain contaminants that results in unwanted traps in the final SiO₂ layer preventing proper charge storage.

### DESCRIPTION / SUMMARY OF THE INVENTION

It is the purpose of the invention to provide an improved method for nanocrystal fabrication inside a semiconductor-oxide layer where the positioning, the size and the density of nanocrystals are controlled.

This purpose is achieved by a method for production of a layered structure with nanocrystals in a dielectric layer, the method comprising
- providing on a substrate a first layer of a first dielectric,
- providing on top of the first layer a second layer made of a first semiconductor,
- providing on top of the second layer a further layer made of a second dielectric,
- thermal treatment in a nonreactive or reducing gas atmosphere at a temperature suitable for production of nanocrystals made of the first semiconductor,
*characterised in that* the second layer is provided by deposition of the first semiconductor using molecular beam epitaxy or chemical vapour deposition under high vacuum conditions.

High vaccum condition, in this context means preferably less than 10⁻¹⁰ Torr, though also a pressure of 10⁻⁸ Torr would be applicable.

By using molecular beam epitaxy (MBE) or chemical vapour deposition (CVD) under high vacuum conditions for the production of such kind of layered structures, the production process is by far more controlled than radio frequency sputtering or atmospheric pressure CVD. Thus, thinner layers, for example layers of thicknesses between 0.5 nm and 1 nm, and smaller nanocrystals can be produced, and by far less defects and non-desirable dopants are introduced in the layers as compared to other methods. Also, the nanocrystals can be positioned at sharply defined distances from the substrate, for example Si. These factors are essential for the manufacture and the properties of memory devices.

The temperature for the thermal treatment should be suitable for production of nanocrystals made of the first semiconductor. Suitable in this context means high enough for the nanocrystal production but not too high in order to avoid substantial segregation, decomposition and/or evaporation of the nanocrystals.

By using MBE or CVD, a large variety of candidates are available as first semiconductor in the second layer. Ge and Si are known candidates, but also compounds made of Si₁₋ₓGeₓ, where x may have a value of between 0 and 1, are usable being able to vary the band gap between 0.66 V and 1.12 V, which are the band gap values for Ge and Si, respectively, and the work function. Being incorporated into SiO₂, the nanocrystals of SiGe alloys will probably permit to vary the parameters and characteristics of MOS transistors and memory devices. SiC, alpha-Sn, and GaN are other candidates, which may be used for possible variation of the parameters and characteristics of MOS transistors and memory devices. They can be also used in light-emitting devices. Finally, III-IV semiconductor compounds should be mentioned. GaAs, InP, InAs, GaP, etc. are direct band semiconductors with different band gap. Being incorporated in SiO₂, they can be used for enhancement of the light emission as well as for memory devices.

A variety of candidates also exist as dielectrics, of which a non-exhausting list imcludes SiO₂, which is well known.

Silicon oxynitride is a promising material for sub-micron MOS ultra-thin gate insulators due to its high radiation hardness, low defect density, high dielectric constant, low gate threshold shifts and low impurity diffusion. The improved dielectric reliability is mainly due to the pile-up of the incorporated nitrogen in the vicinity of the SiO₂/Si interface, in case a Si substrate is used. The Si-N bonds replace the strained Si-O bonds at the SiO₂/Si interface, decreasing the interface strain.

High-k gate dielectric materials (HfO₂, ZrO₂, Al₂O₃, Y₂O₃, Gd₂O₃, etc.) have high dielectric constants, which allows further development of CMOS VLSI. For example, to ensure higher gate oxide capacitance, the SiO₂ layer thickness advantageously is decreased to less than 2 nm, and it should be below 1.5 nm in future devices. At this thickness, SiO₂ can no longer be considered as an insulator. Only a thicker insulator with a dielectric constant higher than that of SiO₂ could reduce the leakage current while still keeping the capacitance high.

ZrO₂ and HfO₂ are leading candidates for alternative gate dielectric. Their dielectric constant is around 25. The thermal stability next to Si is very good up to 900°C. Their band offsets and barrier heights are suitable. However, ZrO₂ is polycrystalline and therefore creates problems connected with local dielectrics uniformities, low leakage current etc. It is also very transparent to oxygen and small partial pressure of oxygen will result in undesirable SiO₂ formation.

Al₂O₃ has a significant interest due to interfacial and chemical properties of grown Al₂O₃ by atomic layer deposition.

Y₂O₃ and Gd₂O₃ have a considerable interest due to relatively high dielectric constants (14-18). However, these oxides are extremely susceptible to hydroxide formation when exposed to the ambient atmosphere.

In experiments, it has been observed that suitable small crystals of Ge have been obtained after thermal treatment of a structure containing a Ge layer with a thickness of 0.5-1 nm. However, if the Ge layer was thicker than 1 nm, the crystal sizes also increased.

The first layer may be provided by MBE or CVD. This assures that the desired thickness is achieved with high precision which may be crucial for the functioning of the final device, for example a memory device. In addition, the dielectric deposited layers by these methods have only very few defects and very few non-desirable dopants.

Also, the further layer may be produced by MBE or CVD. The further layer may be provided by deposition of a semiconductor, for example Si, on top of the second layer, for example a Ge layer. The layered structure, for example Si/Ge/SiO₂, is exposed to thermal oxidation prior to the thermal annealing in order to achieve a high quality semiconductor-oxide layer, for example SiO₂, surrounding the first semiconductor, for example Ge. Such thermal oxidation is typically performed between 750°C and 1000°C for a time that is dependent on the temperature. Examples of parameters for this thermal oxidation are 800°C for 10-20 minutes or 1000°C for 30-300 sec.

Advantageously, the first layer is provided by thermal oxidation of said substrate prior to deposition of said second layer. For example, the first layer may be the oxidised top part of a semiconductor, for example SiO₂ on a Si-substrate. Such oxidised top layer may be achieved by rapid thermal oxidation of a Si substrate in an oxidising atmosphere, for example in oxygen at 1140°C for 120 seconds, prior to deposition of the second layer.

Alternatively, the first layer is provided by provision of a layer made of a second semiconductor, for example Si, preferably as part of the substrate, and wherein the layered structure is exposed to anodic oxidation at room temperature prior to thermal oxidation.

As the first layer should be rather thin for use in memory devices, it advantageously has a thickness of less than 20 nm, preferably between 4 nm and 7 nm.

The further layer, which may be used as a top layer, covers the nanocrystals and may be a varying thickness. If Si is deposited on top of a Ge layer, a thickness of 4 nm may easily be deposited by MBE. The layer thickness of the final SiO₂ after oxidation will in this case increase to 8 nm due to the accumulated oxygen. Using anodic oxidation of Si, a top-SiO₂ layer of 4-10 nm is easily possible.

With the method above, it is possible to produce a layered structure with nanocrystals embedded in the interface between a first dielectric layer with a first dielectric and a further dielectric layer with a second dielectric, wherein more than 90% of the nanocrystals have a diameter of less than 10 nm, and preferably 80 % of the nanocrystals have a diameter smaller than 6 nm.

The nanocrystals produced by the above described method have a density of higher than 10¹¹ cm⁻². Densities as high as 4·10¹² cm⁻² have been obtained, and even higher densities are possible. However, if the density get too high, charge exchange may occur between the nanocrystals. This undesirable cross talk have been experienced with nanocrystals with a diameter of 2 nm and a density of 4·10¹² cm⁻². Therefore, the density range of 1·10¹¹ cm⁻² to 5·10¹¹ cm⁻² is proposed to be optimum for production of memory devices.

The method described above and the produced structure is applicable for production of memory devices, photoluminescence devices, optical switches, capacitors, MOS transistors or other MOS devices.

### SHORT DESCRIPTION OF THE DRAWINGS

The invention will be explained in more detail with reference to the drawing, where
- FIG. 1: is s schematic drawing and a TEM micrograph of a layered structure according to one embodiment of the invention,
- FIG. 2: is s schematic drawing and a TEM micrograph of a layered structure according to another embodiment of the invention,
- FIG. 3: is a scheme for the method according to approach I,

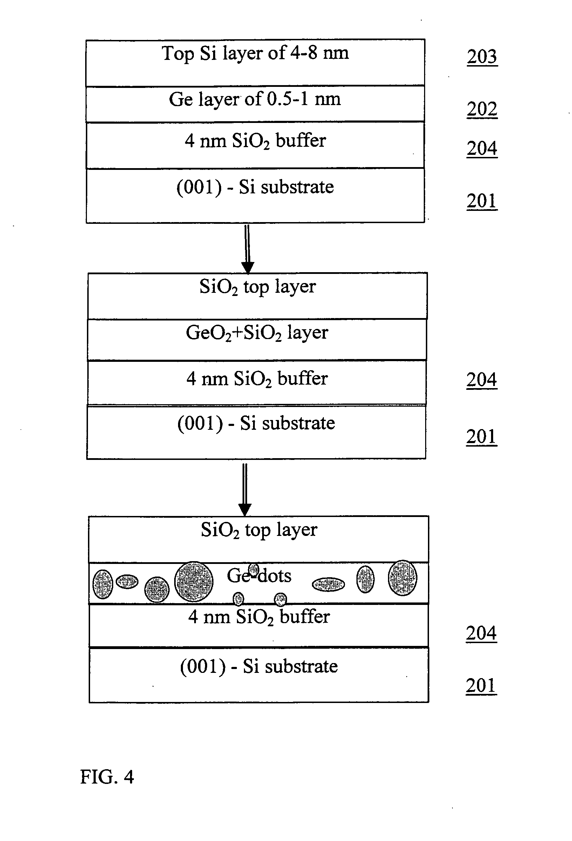

- FIG. 4: is a scheme for the method according to approach II,
- FIG. 5: is an RBS spectrum for Ge in approach I,
- FIG. 6: is a plan-view TEM micrograph of Ge nanocrystals in SiO₂,
- FIG. 7: are diagrams for the size distribution of Ge nanocrystals in approach I and approach II,
- FIG. 8: is a cross sectional TEM micrograph of a structure according to approach I,
- FIG. 9: is an RBS spectrum for Si and Ge in approach II,
- FIG. 10: shows plan-view TEM micrographs of Ge nanocrystals,
- FIG. 11: shows TEM micrographs of a structure according to approach II in a cross sectional view.

### DETAILED DESCRIPTION / PREFERRED EMBODIMENT

The main technological target of the project is the use of nanocrystals in memory devices. In connection with such electronic memory devices, one of the main advantages of the invention is the possibility to precisely tune the nanocrystal layer distances from the channel and from the gate electrode making the distances smaller than allowed for structures based on polysilicon, thus allowing to scale down the thickness of the gate oxide. Consequently, it is easier to charge the nanocrystals using much lower voltages than actually used in floating-gate NVM devices. By providing the nanocrystals even closer to the interfaces, write-erase times are further decreased at the expense of the retention time, thus approaching DRAM performances. The control of the density of the nanocrystals is important for the retention time since the crystals should not electrically "communicate". Charge can eventually be lost by some nanocrystals located close to the drain region - as it is for example the case of the polysilicon layer in NVM devices - but, because they are isolated from each other, the majority of nanocrystals will retain their charge.

The control at the nanometer level of all the parameters related to the nanocrystals is of paramount importance because the devices could be tuned to have NVM or DRAM properties by only slightly changing one or more of these parameters. This means that by slightly modifying the process, it is possible to make either type of memory device. This is an important breakthrough over the current trend towards a higher level of integration in which the different type of memory devices are mixed with logic.

In the following, the formation of molecular-beam epitaxially (MBE) grown, self-assembled Ge nanocrystals in a layer of SiO₂ on a Si single crystal substrate is described. However, other materials for the substrate and the layered structure are possible and chemical vapour deposition (CVD) may be used instead of MBE.

Explained in the following are two main approaches that have been verified experimentally: Approach I using anodic oxidation, and Approach II using a thin SiO₂ buffer as a barrier for Ge segregation.

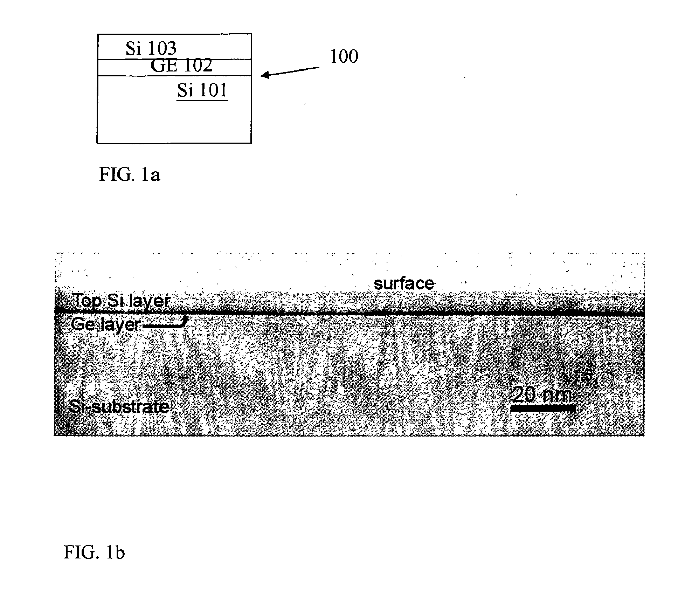

In Approach I, a sandwiched structure 100 of Si/Ge/Si-substrate as illustrated in FIG. 1a was grown by MBE, in which the thin Ge layer 102 was 0.5-1 nm in thickness on top of the Si substrate 101. The Si top layer 103 had a thickness of 4-8 nm. A cross sectional transmission electromicrograph (TEM) of this sandwich-structure is shown in FIG. 1b, with a Si substrate covered with the Ge layer being easily visible due to its high contrast. The structure 100 was anodically oxidized at room temperature in order to achieve a SiO₂ on both sides of the Ge. Subsequently, the sample was thermally oxidized at high temperatures for improvement of the structural quality of anodic SiO₂. No migration of the Ge was observed as a result of this oxidation. This is at least partly due to the fact that the initial Si layer underneath the Ge had been oxidised by anodic oxidation at room temperature beforehand, where the temperature is too low for Ge migration, such that during the subsequent thermal oxidation, a migration of the Ge along any Interface could not occur.

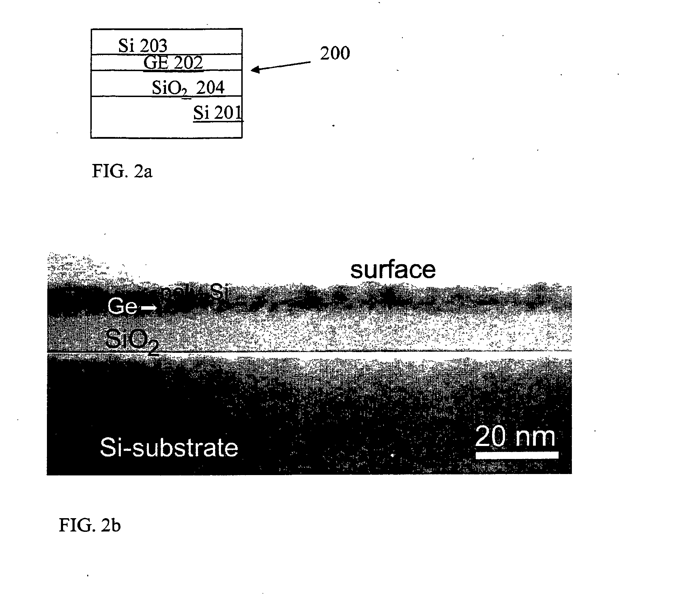

In Approach II, as illustrated in FIG 2a, a sandwiched structure 200 of Si/Ge/SiO₂/Si-substrate was prepared by using rapid thermal oxidation of the Si substrate 201 to form a SiO₂ first layer 204 followed by MBE growth of a Ge layer 202 of 0.5 nm - 1 nm thickness and a Si layer 203 of about 5.5 nm thickness. A cross sectional electron micrograph is shown in FIG. 2b. This structure was thermally oxidized at 790-800°C for 20 min, where no migration of the Ge was observed. As an alternative to rapid thermal oxidation, oxidation in a standard furnace could have been used.

Finally, in both approaches, a rapid thermal reduction in a nitrogen ambiance was performed. Both approaches were able to produce Ge nanocrystals of an average size of about 4-10 nm and of a surface density as high as 2·10¹¹ cm⁻² to 5·10¹¹ cm⁻², in a two-dimensional (2-D) array located within a SiO₂ layer. In a later experiment, nanocrystals of rather uniform diameter of 4 nm and a density of 4·10¹² cm⁻² were achieved. These results, however, are not shown in the following.

The configuration of the layers determines the final thickness of the SiO₂ layer as well as the surface density, size distribution and depth location of the Ge nanocrystals. The MBE approach is precise, clean and reproducible. In contrast to implantation techniques, the layers achieved by a method according to the invention do not contain radiation-induced defects which may influence the diffusion and segregation of the Ge atoms in the thin SiO₂ layer during subsequent processing.

In the following, a more detailed explanation of the experimental conditions and the results is given for the two approaches.

### Approach I : Anodic oxidation of a Si/Ge/Si structure

In this approach with reference to FIG. 1, different samples 100 have been grown in which the thickness of the Ge layer 102 and the Si-capping layer 103 were varied within 0.5-1 nm and 4-8 nm, respectively. A VG Semicon V80 system was used for the MBE growth. The growth was carried out at a temperature of 420°C at a growth rate of 0.5 Å/sec. A typical as-grown structure, determined by cross-section TEM, is shown in FIG.1b; flat and sharp interfaces between the Ge and Si layers as well as a good crystalline quality of the structure are demonstrated. No extended defects were found in the layers.

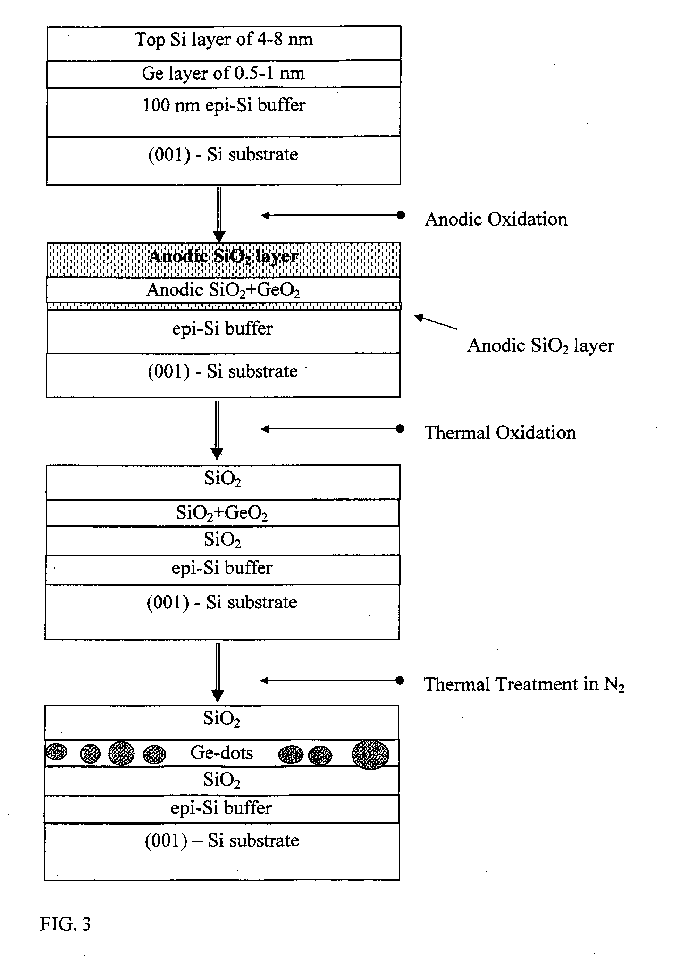

The method for nanodot fabrication is illustrated in FIG. 3, where the initial structure shown in the upper part of the image being similar to FIG. 1a. The second stage of the sample preparation is the oxidation process of the MBE grown sandwich-structure 100 with the aim of incorporating the Ge layer 102 inside the SiO₂ layers 101, 103. The major problem here is how to avoid that the Ge segregates near the moving SiO₂/Si interface during the oxidation process. Ge segregation is destructive because it pushes the Ge out of the oxide layer and creates a SiGe alloy layer at the Si/SiO₂ interface.

Anodic oxidation 105 was found to be an effective method for surface oxidation and final incorporation of the Ge into the SiO₂ layer. We have therefore concentrated on a two-stage procedure for the oxidation of the structures. The first stage was room temperature anodic oxidation to grow a surface SiO₂ layer of a thickness just sufficient to incorporate the Ge layer.

The following oxidation conditions were applied. The anodic oxidation was done in a solution of 0.04 M KNO₃/ ethylene glycol/ 0.3% H₂O at a potential of 50 V between the sample and the Pt counter electrode. The samples were subsequently cleaned in a mixture of HCl-H₂O₂-H₂O, and dried at 400°C in a nitrogen ambiance. The result of the anodic oxidation is illustrated in FIG. 3.

The second stage of oxidation was carried out in a dry, pure oxygen ambiance at a temperature of 450°C for 1-2 hours to drive out any possible volatile components of the anodic oxide layer (such as hydrogen atoms, H₂O molecules, etc.), followed by a 30 - 60 minutes thermal oxidation at 800 - 1000°C to produce the 2-5 nm thin thermal oxide layer at the SiO₂/Si interface and to improve the structural quality of the anodic SiO₂. Anodic oxidation introduces point defects and dopants in the oxide from the solution. Also, small voids can occur in the anodic oxide. These defects, dopants and voids are removed by thermal oxidation. Furthermore, possible surface contamination due to the oxidation in the solution are removed in this stage. In addition, thermal oxidation results in a thickening of the SiO₂ layer between the Ge layer and the Si substrate providing preferred electrical properties, for example a good capacitance. We expect that GeO₂ nanoclusters are formed at this stage.

A crucial process in the production of the Ge nanocrystals in the SiO₂ layer is the transformation of the GeO₂ nanoclusters into Ge nanocrystals. This has been done by a reduction process using rapid thermal annealing (RTA) in a pure nitrogen ambiance, where a J.I.P.Elec JetFirst-100 system was used. Involving Si monomers, this reduction process may be illustrated in a simplified manner as GeO₂ + Si → SiO₂ + Ge. The reduction temperature and time were varied between 900 and 1100°C and 60 - 360 sec, respectively. In order to prevent or at least minimise Ge segregation, this temperature is chosen as low as possible but still high enough to achieve the desired results.

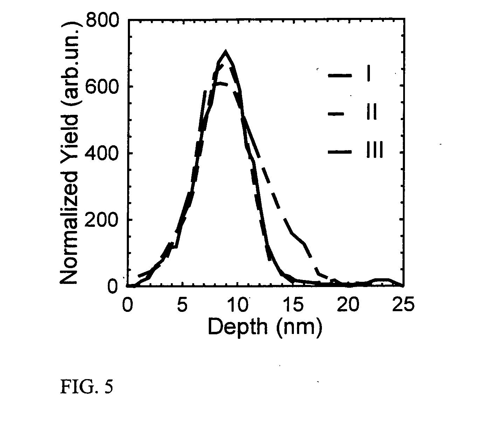

A very important feature of anodic oxidation follows from the Rutherford backscattering data presented in FIG. 5 showing only the Ge part of the signal. High resolution spectra were obtained from the as-grown sample (curve I in FIG. 5), after anodic oxidation including the high temperature thermal oxidation stage (curve II) and after the reduction procedure carried out in a nitrogen atmosphere at 900°C for 60 s (curve III). Neither location nor shape of the depth concentration profile of the Ge change during the anodic oxidation as can be concluded from the obvious similarity between curve I and curve II in FIG. 5. Thus, the additional thermal oxidation at temperatures as high as 800 - 1000°C for 30 min of the anodically oxidized sample does not result in any visible redistribution of the Ge.

As also can be seen from the comparison of curve II with curve III in FIG. 5, a very small (less than 10%) decrease of the Ge peak concentration as well as a minor broadening of the Ge profile occurs. This is thought to be a consequence of the Ge nanocrystal formation. Thus, this high temperature stage does not change the depth location and concentration profile of the incorporated Ge proving that out-diffusion of Ge does not occur to a noticeable degree.

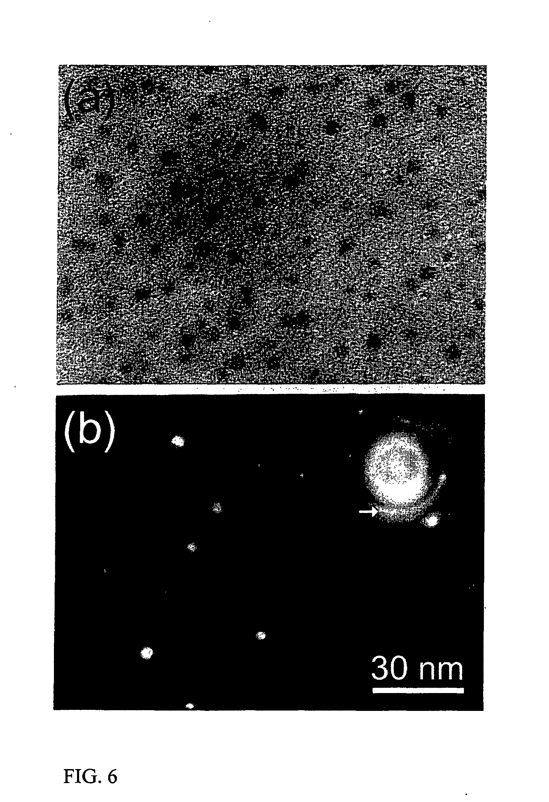

Also, following the reduction process, the samples were investigated by transmission-electron microscopy (TEM) as illustrated in FIG. 6. showing plan-view TEM micrographs of Ge nanocrystals incorporated in a 20 nm thin SiO₂ layer. The Ge nanocrystals are dark spots in a bright-field TEM image (a) and bright spots in the dark-field (DF) TEM image (b). The DF TEM micrograph has been obtained in (220)-reflections taken at a diffracted ring, which is indicated by an arrow at the diffraction pattern inserted in the top-right corner of (b).

The samples for TEM investigations were prepared for both plan-view and cross-section geometries. A Philips CM20 microscope operating at 200 kV was used.

Analysis by energy dispersive x-ray spectrometry was carried out using a Philips CM20/EDAX PV9800 instrument.

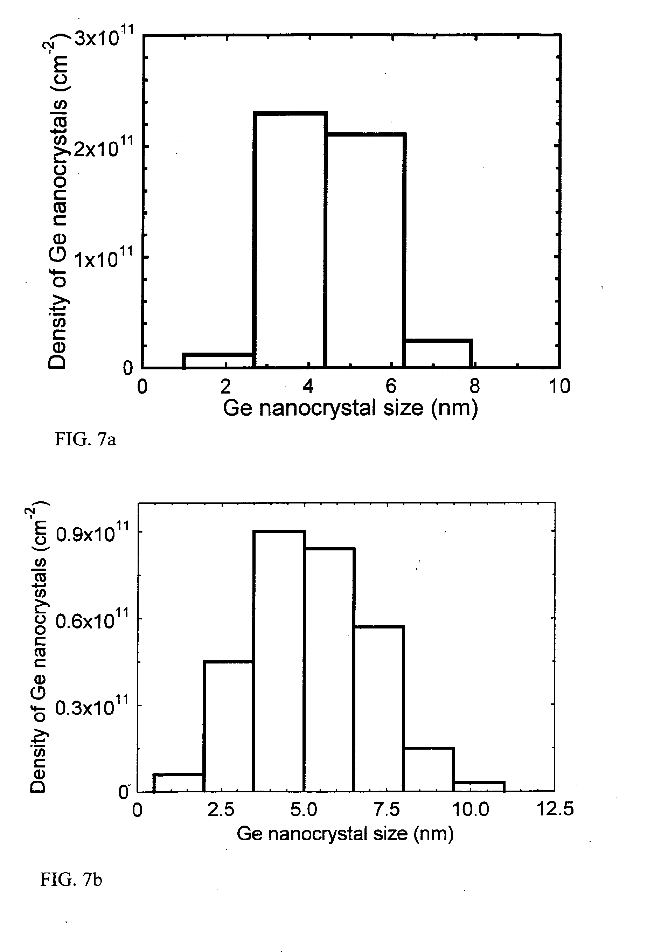

Figure 6 gives clear evidence of Ge-nanocrystal formation in the SiO₂ layer during the reduction process. The bright field plan view TEM image, FIG. 6a, reveals a clear contrast between the. spherically shaped particles (dark circles) and the SiO₂ layer. Although a few nanoparticles coalesce, most of them are separated from each other. The particles have excellent size uniformity as presented in FIG. 7a, demonstrating that most of the particles have a size between 3 and 6 nm. The density of the particles in the plane as it is imaged in FIG. 6 is 4.7x10¹¹ cm⁻².

A selected area diffraction pattern taken from the region containing the particles display the existence of semi-diffused polycrystalline rings; one of them, corresponding to the 2-2-0 reflections of Ge, is indicated by an arrow in the inserted diffraction pattern of FIG. 6b. Clear evidence that the particles are Ge nanocrystals follows from FIG. 6b, where a dark-field TEM image is produced by using the above 2-2-0 diffraction ring. The use of these reflections results in the formation of spots with a bright contrast in the dark field image due to diffraction at the Ge crystalline particles. Additional evidence of the Ge nature of the particles was obtained from energy dispersive x-ray measurements (not shown).

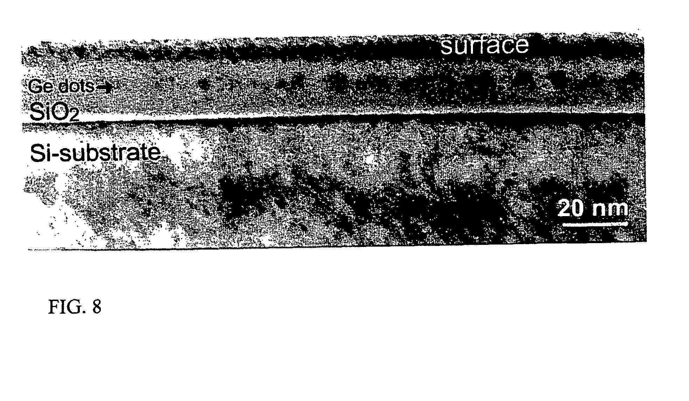

Figure 8 shows a cross-section TEM micrograph of a sample after the oxidation process and a reduction process in nitrogen atmosphere at 900°C for 60 s. The micrograph demonstrates very nicely that Ge nanocrystals are formed in the very middle of the 20 nm thick SiO₂ layer. The Ge nanocrystals are spherically shaped and isolated from each other with excellent in-plane location positioned at a distance of about 10 nm from the Si/SiO₂ interface. The quality of the SiO₂ layer and the SiO₂/Si interface is found to be very good as judged from the XTEM analysis.

### Approach II: Thermal oxidation of a Si/Ge/SiO₂/Si structure.

In this approach, a Ge layer with thickness of 1 nm and a Si layer with a thickness of 5.5 nm were grown by MBE on the SiO₂/Si wafer. This wafer was produced prior to MBE growth by oxidation of a standard Si wafer in the RTA chamber at 1140°C for 120 sec in a dry O₂ atmosphere, resulting in a 13-17 nm thick oxide layer on the wafer surface. In later experiments not presented here, we were able to produce a thickness of the SiO₂ layer of 4 nm by RTA as well as in a conventional furnace. For this, an RTA temperature of 1100°C was applied for 30 sec, or alternatively, a thermal oxidation was performed at 800°C for 10-20 minutes in a conventional furnace.

The subsequent MBE growth of the top Ge and Si layers was carried out at a temperature of 420°C at a growth rate of 0.5 Å/sec. A typical as-grown structure, determined by cross-section TEM, is shown in FIG. 2b. Due to the MBE growth on the amorphous SiO₂ surface, the structure of the top Si/Ge layers is polycrystalline with an average grain size of about 2-6 nm. The interfaces between Ge and SiO₂ as well as between Ge and the top poly-Si layer are gentle and only rough in nano-scale range. No extended defects were found neither in the Si substrate nor at the SiO₂/Si interface, which is flat and sharp.

The subsequent stage of the sample preparation was the oxidation of the MBE grown top Si/Ge layers. We have found the approximate regimes of oxidation which allow the incorporation of Ge inside the SiO₂ layer without a strong segregation or out-diffusion of the Ge. For the case of the sample used with a Si top layer thickness of 5.5 nm, the optimal condition of oxidation was determined to be 800°C for 20-23 min in a O₂-flow of about 1.5 l/min.

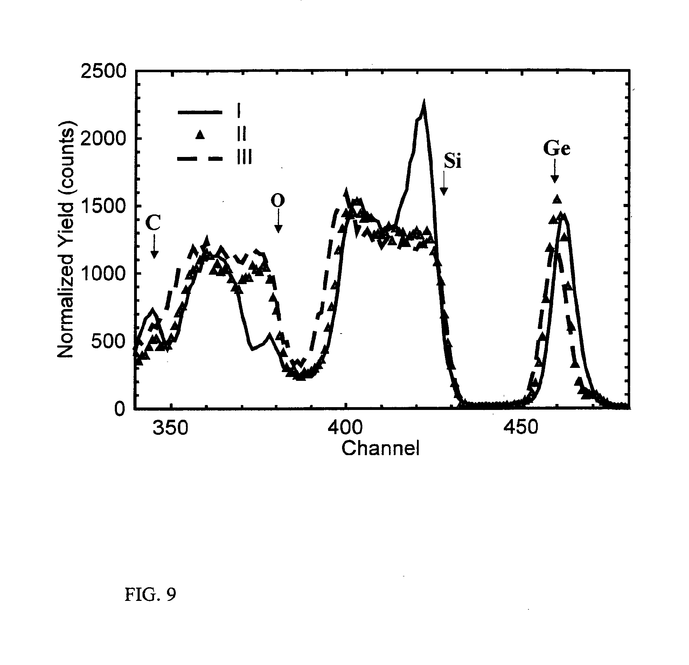

Figure 9, shows RBS/C spectra obtained from the as grown sample (I), after the furnace oxidation at 800°C for 20 min (II) and followed by the reduction procedure in an nitrogen atmosphere at 900°C for 60 s (III). The positions of the Ge, Si, and oxygen containing surfaces are indicated by arrows together with a carbon background signal. The spectrum demonstrates that in the above mentioned conditions of oxidation, neither the position nor the shape of the Ge concentration profiles change during the thermal oxidation.

In addition, very similar optimal conditions were obtained in the case of oxidation at lower (or higher) temperature but for longer (or shorter) time for thermal treatment. However, it was established that the top Si/Ge layers may not be fully oxidized if the temperature and/or time of the annealing are well below the optimal values. On the other hand, according to other high-resolution RBS measurements (not shown), it could be concluded that a strong out-diffusion of Ge takes place when the temperature and/or time of the annealing are/is well above of the optimal values.

Similar to the anodic oxidation approach, the reduction process with Si monomers (GeO₂ + Si → SiO₂ + Ge) was carried out using RTA in a pure nitrogen ambiance at the temperature of 900°C for 60 sec. After the reduction process, the samples were investigated with high-resolution RBS/C technique as well as with TEM in both plan-view and cross-section geometries. Also in this case it could be concluded that no visible out-diffusion of Ge or changes of the depth position of the Ge- peak concentration take place during the reduction procedure. This is clearly seen from the high-resolution RBS spectra presented in FIG. 9 where the Ge signal remains approximately constant for the three situations.

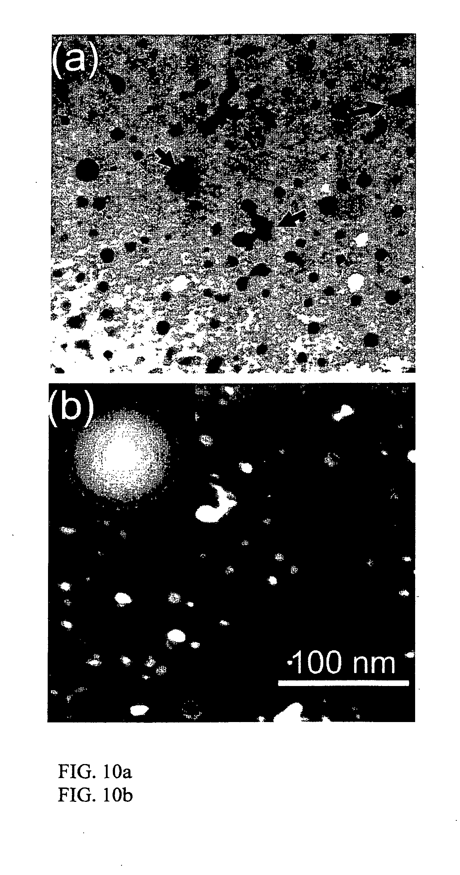

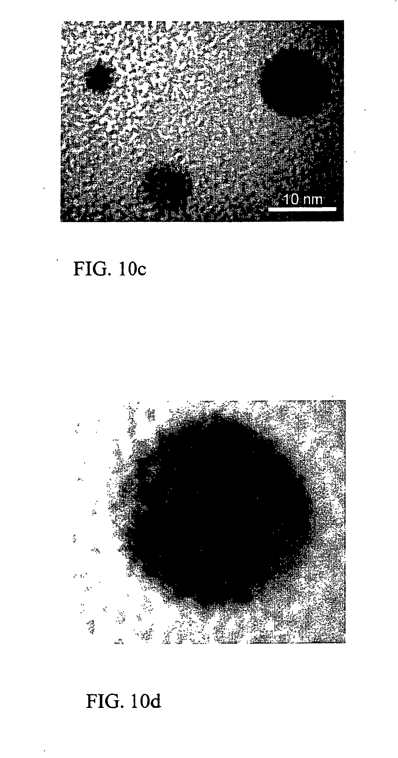

Figure 10 demonstrates the Ge nanocrystal formation in the SiO₂ layer. It shows a plan-view TEM micrographs of Ge nanocrystals incorporated in the SiO₂ layer of the Si/Ge/SiO₂/Si structure after oxidation at 793°C for 20 min followed by RTA reduction at 900°C for 60 s. The Ge nanocrystals are dark spots in the BF TEM image on FIG. 10a and bright spots in the DF TEM image of FIG. 10b. The diffraction pattern is inserted in the top-left corner of FIG. 10b. The bright field and dark-field plan-view TEM images reveal a good contrast of the Ge particles - dark spots in bright field and bright spots in dark field. The surface density of the Ge particles is about 2x10¹¹cm⁻², which is more than two times less as compared to the anodized samples.

The size distribution is shown in FIG. 7b. As compared to the anodically oxidized samples, the nanocrystals are less uniform in size. However, more than 90% of the crystals are smaller than 10 nm. The largest particles have non-spherical shapes, probably due to a strong coalescence of the small particles. This coalescence process results in a broadening of the measured size-distribution profile which is shown in FIG. 7b with an average size of the nanocrystals of about 5 nm.

A selected area diffraction pattern - see the insertion in the top-left corner of the FIG. 10b - taken from a region containing nanocrystals demonstrates the existence of both semi-diffused and sharply-dotted polycrystalline rings which is also indicative of a broad size distribution of the Ge particles.

High-resolution TEM images are shown in FIG. 10c and FIG. 10d, the latter being a magnification of the upper right particle in FIG. 10c. Across the particle in FIG. 10d, a linear pattern from upper left to lower right can be seen, demonstrating lattice resolution of the Ge particles. More precisely, the linear pattern shows the (111) planes of Ge in this crystal. This clear evidence of the crystalline nature of the particles proves that a conversion of the Ge layer 202 into crystalline nanoparticles indeed takes place during the process.

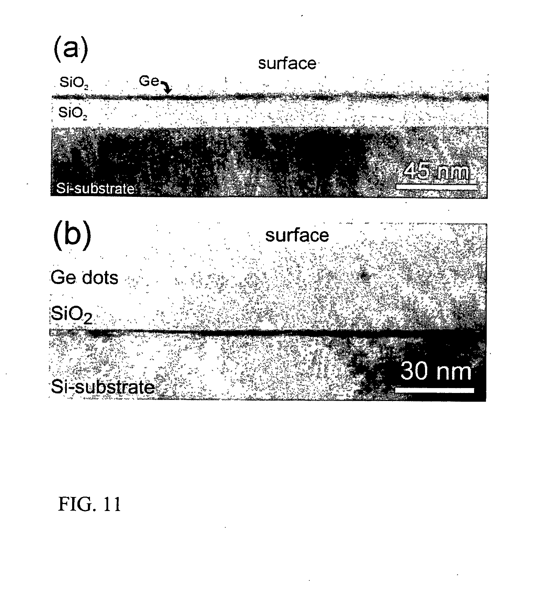

Plan-view TEM images of several large-size Ge particles display displacement/thickness fringe contrast (indicated by the arrows in the FIG. 10a) which is a clear indication of plate-like and lens-shaped structures of the large Ge particles. An additional evidence of this plate-like structure is the micrograph in FIG. 11a presenting a cross-section TEM image of the same sample as that of FIG. 10. Opposite to their large plan-view dimensions, the cross-section thickness of most of the Ge particles is only 1-3 nm.

The cross-sectional image of FIG. 11a has been obtained with a sample oxidised at 793°C for 20 min followed by the reduction process at 900°C for 60 sec in a nitrogen atmosphere. Changing the oxidation temperature only a few degrees, the particles appear not plate like any longer but have a more spherical shape, as revealed by FIG. 11b obtained with particles oxidised at to 800°C. This demonstrates how sensitive the process is to temperature variations. By the latter process and as shown in FIG. 11b, nearly spherical Ge particles are fabricated well isolated from each other and located just in the middle of SiO₂ layer.

### Conclusion

In conclusion, we have successfully produced thin SiO₂ layers with incorporated self-assembled Ge nanocrystals. Using both approaches we are now able to produce Ge nanocrystals in a two-dimensional (2-D) array within SiO₂ on top of a Si substrate. With Approach I the sizes of the Ge nanocrystals are between 3-6 nm and the density as high as 5x10¹¹ cm⁻², whereas Approach II results in even higher nanocrystal density and in similar size distribution. We believe that these numbers can be slightly changed due to process optimization.

## Claims

1. A method for production of a layered structure with nanocrystals in a dielectric layer, the method comprising
- providing on a substrate a first layer of a first dielectric,
- providing on top of said first layer a second layer made of a first semiconductor,
- providing on top of said second layer a further layer made of a second dielectric,
- thermal treatment in a nonreactive or reducing gas atmosphere at a temperature suitable for production of nanocrystals made of said first semiconductor,
***characterised in that*** said second layer is provided by deposition of said first semiconductor using molecular beam epitaxy or chemical vapour deposition under high vacuum conditions, preferably less than 10⁻⁸ Torr.

2. A method according to claim 1, wherein said second layer is provided with a thickness of less than 1 nm.

3. A method according to claim 1 or 2, wherein the first semiconductor is at least one from the group consisting of Ge, Si, Si₁₋ₓGeₓ, SiC, alpha-Sn, GaN, and a III-IV semiconductor compound.

4. A method according to claim 1, 2 or 3, wherein said first dielectric and/or said second dielectric is at least one from the group consisting of SiO₂, Oxinitride, Al₂O₃, Y₂O₃, Gd₂O₃, ZrO₂, HfO₂, and a high k-gate dielectric material.

5. A method according to any single of the claims 1 - 4, wherein said first and/or said second dielectric is provided by chemical vapour deposition or molecular beam epitaxy.

6. A method according to any single of the preceding claims, wherein said further layer is provided by deposition of a semiconductor, preferably Si, on top of said second layer and wherein said layered structure is exposed to thermal oxidation prior to said thermal treatment for achieving a high quality semiconductor-oxide, preferably SiO₂, layer surrounding said first semiconductor.

7. A method according to any single of the claims 1 - 6, wherein said first layer is provided by thermal oxidation of said substrate prior to deposition of said second layer.

8. A method according to any single of the claims 1 - 6, wherein said first layer is provided by provision of a layer made of a second semiconductor, preferably as part of said substrate, and wherein said layered structure is exposed to anodic oxidation at room temperature prior to thermal oxidation.

9. A method according to any single of the claims 1 - 6, wherein said first layer has a thickness of less than 20 nm, preferably between 4 and 7 nm.

10. A layered structure with semiconductor nanocrystals embedded in the interface between a first dielectric layer and a further dielectric layer, ***characterised in that*** more than 90% of said nanocrystals have a diameter of less than 10 nm.

11. A layered structure according to claim 10, wherein more than 80% have a diameter less than 6 nm.

12. A layered structure according to claim 10 or 11, wherein said nanocrystals have a density of higher than 10¹¹ cm⁻².

13. Application of a method according to any of the claims 1 - 9, or a layered structure according to any of the claims 10 - 13 for production of a memory device, a photoluminescence device, an optical switch, a capacitor, or a MOS transistor or other MOS devices.
